# EUROPEAN PATENT APPLICATION

(11) **EP 4 365 639 A1**
(43) Date of publication of application: **08.05.2024**
(21) Application number: 22833675.6
(22) Date of filing: 30.06.2022
(51) Int. Cl.: G01T 1/24, H10K 30/00, H10K 99/00

(54) **RADIATION DETECTION DEVICE AND METHOD FOR MANUFACTURING SAME**

(30) Priority: 30.06.2021 KR 20210086070
(71) Applicant: Korea Atomic Energy Research Institute, Daejeon 34057 (KR)
(72) Inventor: KIM, Su Jin, Seoul 02715 (KR); KANG, Chang Goo, Gwangju 62053 (KR); PARK, Jeongmin, Hwaseong-si, Gyeonggi-do 18447 (KR); KIM, Young Soo, Daejeon 34140 (KR); KIM, Han Soo, Jeonju-si, Jeollabuk-do 54859 (KR); CHOI, Hyojeong, 34895 Daejeon (KR); KIM, Byeong Hyeok, Jeongeup-si, Jeollabuk-do 56212 (KR); HA, Jang Ho, Jeonju-si, Jeollabuk-do 54861 (KR)
(74) Representative: Cabinet Beau de Loménie
(86) International application number: PCT/KR2022/009451
(87) International publication number: WO 2023/277621

(57) **Abstract**

The present invention relates to a radiation detection device and a method for manufacturing same. The radiation detection device of the present invention comprises: at least one bottom electrode and at least one top electrode disposed spaced apart from each other; and a semiconductor substrate disposed between the bottom electrode and the top electrode, wherein the upper end of the semiconductor substrate includes at least one active layer region, and the active layer region is filled with a nanocomposite including zero-dimensional nanoparticles, conductive polymers, and one-dimensional or two-dimensional conductive nanomaterials.

## Description

### [Technical Field]

The present invention relates to a novel type of radiation detection device and a method for manufacturing the same.

### [Background Art]

In general, a semiconductor radiation detector may generate charges (electrons and holes) within a detection device by ionization of incident radiation, and collect the charges by an electric field applied between both electrodes to detect the incident radiation as a signal.

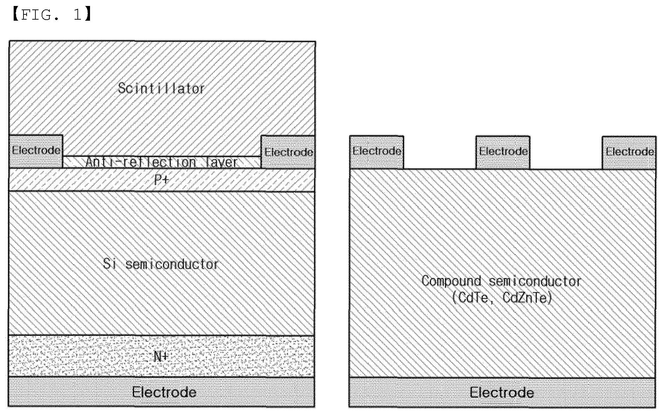

In terms of structure, a semiconductor type radiation detector that has been widely used conventionally is divided into a combined type (left side in FIG. 1) of scintillator-semiconductor photo detection device (photodiode) and a bulk type detector (right side in FIG. 1) using a single crystal material having atomic number (Z) and high density. In terms of the detection method, the combined type is classified as an indirect detection method, and the bulk type is classified as a direct detection method. In general, the direct detection method that goes through a simple conversion process is a detection method that has excellent resolution compared to the indirect detection method.

For example, the combined type of the scintillator-semiconductor photodetection device is the indirect detection method that converts the radiation incident into the scintillator into light in the visible wavelength range, absorbs the light converted by the photodetection device, and detects converts the absorbed light into an electrical signal for detection, and has a problem in that light efficiency is reduced due to light scattering occurring in a scintillator layer.

On the other hand, the direct detection method is based on the principle that CdTe or CdZnTe single crystals, which are compound semiconductor materials that have sufficient stopping power and exhibit excellent resolution characteristics, are widely used, when radiation is incident and absorbed, electrons and holes are generated in proportion to the incident energy through the ionization and are moved and collected toward an electrode by an external electric field to generate current pulses, the generated current pulses are amplified and classified according to a size and detected, and thus, is a method of solving the indirect detection method.

However, the radiation detector of the existing direct detection method mainly uses bulk type single crystal materials having a high effective atomic number (Z) and high density, but it is very difficult for the single crystal materials to grow into large-area single crystals of 2 inches or more with high purity and uniform quality and the single crystal materials have limitations in large-area processing and mass production due to a high-cost and complex manufacturing process.

For example, the electrons and holes generated by the radiation while making a device are re-trapped at a shallow level due to defects such as impurities, stacking faults, and dislocations in a semiconductor crystal lattice while moving to the electrode or are recombined by deep trap, and thus, are not efficiently collected by the electrode, so charge collection efficiency decreases and energy resolution decreases. In addition, surface trap states may generate a leakage current to lower a signal-to-noise ratio, which may result in reduced detection efficiency and resolution.

Accordingly, the next-generation radiation detector for solving the above problems requires materials specialized for radiation detection and a novel type of device structure to implement a low-cost, simple manufacturing process and high performance of high sensitivity and high resolution.

### [Disclosure]

### [Technical Problem]

In order to solve the above problems,
the present invention provides a novel type of radiation detection device and a method for manufacturing the same.

In detail, the present invention provides a radiation detection device and a method for manufacturing the same capable of achieving high performance such as high sensitivity and high resolution through a low-cost and simple manufacturing process.

### [Technical Solution]

To achieve the above object,
in an aspect of the present invention, a radiation detection device includes: at least one bottom electrode and at least one top electrode disposed at a spaced location; and a semiconductor substrate disposed between the bottom electrode and the top electrode, wherein an upper end portion of the semiconductor substrate includes at least one active layer area, and the active layer area is filled with a nanocomposite including a zero-dimensional nanoparticle, a conductive polymer, and a one-dimensional or two-dimensional conductive nanomaterial.

In another aspect of the present invention, a method for manufacturing a radiation detection device includes: forming at least one active layer area on a semiconductor substrate; filling the active layer area with a nanocomposite including a zero-dimensional nanoparticle, a conductive polymer, and a one-dimensional or two-dimensional conductive nanomaterial; and forming at least one bottom electrode and at least one top electrode on each of the lower and upper portions of the semiconductor substrate in which the active layer area is filled with the nanocomposite.

### [Advantageous Effects]

A radiation detection device of the present invention can reduce trapping and re-trapping of generated carriers while implementing a direct detection method, and exhibit more improved charge collection efficiency than the existing bulk radiation detector by increasing mobility of carriers, thereby improving detection efficiency and resolution.

Specifically, according to the radiation detection device of the present invention, since the movement of carriers is achieved through an electrode structure formed on an upper portion of a three-dimensional vertical type nano-sized semiconductor, it is possible to implement rapid spatial separation of generated electrons and holes, and since a carrier diffusion length may be significantly shortened, it is possible to increase carrier collection by reducing the probability of recombination during the movement of carriers. Accordingly, the charge sharing problem that causes interference between electrode pixels in the existing bulk detector can be fundamentally improved, thereby improving the detection efficiency and resolution.

In addition, according to the radiation detection device of the present invention, it is possible to improve a radiation absorption rate and reactivity through a three-dimensional vertical type pattern having a high aspect ratio formed on a semiconductor.

Furthermore, one-dimensional or two-dimensional nanomaterials of nanocomposites layer filled in the pattern form an additional effective conduction path along with a conductive polymer to contribute to an increase in mobility of carriers, thereby increasing collection efficiency even with a relatively small electric field. Specifically, it is possible to easily control a band gap between heterojunctions and secure additional conductive paths due to the doping of polymer materials and the formation of the composite of conductive nanomaterials.

In addition, unlike the existing P-N junction optical detection device, a method for manufacturing a radiation detection device of the present invention does not require an ion implantation process or a high-temperature diffusion process to reduce the use of high-cost, high-purity bulk single crystal materials, thereby reducing production costs. In addition, the method for manufacturing a radiation detection device of the present invention can be compatible with the existing semiconductor CMOS manufacturing process and has an effect of allowing a detection device to be manufactured in a simple manner through a low-cost process such as a room temperature solution process. Accordingly, there is an advantage in that there is an economic benefit in terms of manufacturing costs, and there is an advantage in increasing the detection efficiency and resolution of the radiation detection device and improving the manufacturing process.

Due to the advantages of the above simple manufacturing method and the excellent characteristics of the radiation detection device, the radiation detection device of the present invention cam maximize the advantages of low power, miniaturization, and lightness to meet the various requirements of the market and consumers and satisfy the convenience of use. Accordingly, as the next-generation radiation detector, it has the advantage of being applicable to various fields such as industry, military, and food as well as medicine. In particular, it has the advantage of securing the original technology for radiation sensors, which are currently dependent on imports by more than 90%, and having the effect of leading the related field beyond achieving technological independence.

### [Description of the Drawings]

The following drawings attached to this specification illustrate preferred embodiments of the present invention, and serve to further understand the technical idea of the present invention along with the contents of the above-described invention. Therefore, the present invention should not be construed as limited to the matters described in such drawings.
FIG. 1 is a schematic diagram of a type (left-indirect type, right-direct type) of a conventional radiation detection device.
FIG. 2 is a schematic diagram of a radiation detection device according to an embodiment of the present invention.
FIG. 3 is a top view of the radiation detection device according to the embodiment of the present invention.

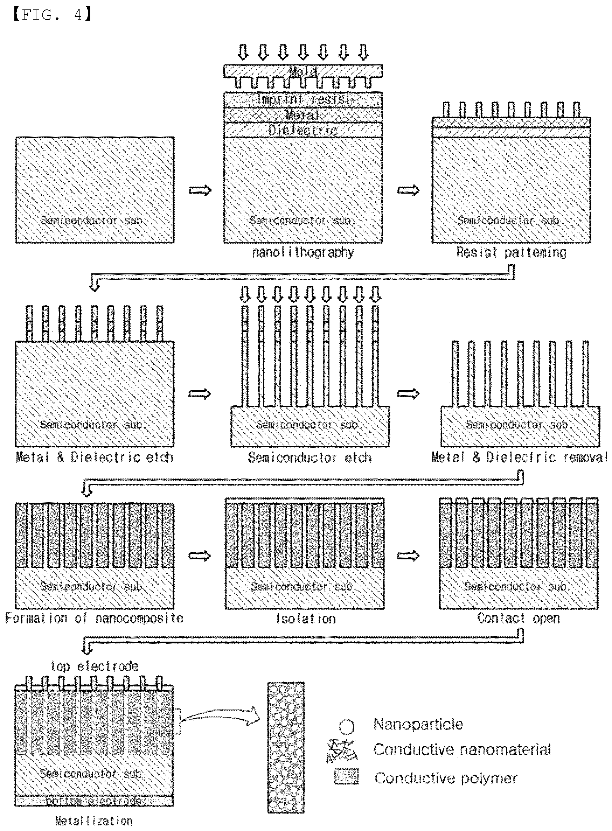

FIG. 4 is a process diagram of a method for manufacturing a radiation detection device according to an embodiment of the present invention.

### [Best Mode]

Hereinafter, various embodiments of the present invention will be described in detail with reference to the accompanying drawings.

The present embodiments may be modified in other forms or various embodiments may be combined with each other, and the scope of the present invention is not limited to the embodiments described below. In addition, these embodiments of the present invention are provided to more completely describe the present invention to those skilled in the art. For example, the shapes and dimensions of elements in the drawings may be exaggerated for clarify the description, and the same reference numerals will be used throughout to designate the same or like components. In addition, the terms used herein such as, 'upper portion', 'upper surface', 'lower potion', 'lower surface', 'side surface', etc. are based on the drawings, and in reality, may vary depending on a direction in which the components are arranged.

One aspect of the present invention provides a radiation detection device.

The present invention includes: at least one bottom electrode and at least one top electrode disposed at a spaced location; and a semiconductor substrate disposed between the bottom electrode and the top electrode, wherein an upper end portion of the semiconductor substrate includes at least one active layer area, and the active layer area is filled with a nanocomposite including a zero-dimensional nanoparticle, a conductive polymer, and a one-dimensional or two-dimensional conductive nanomaterial.

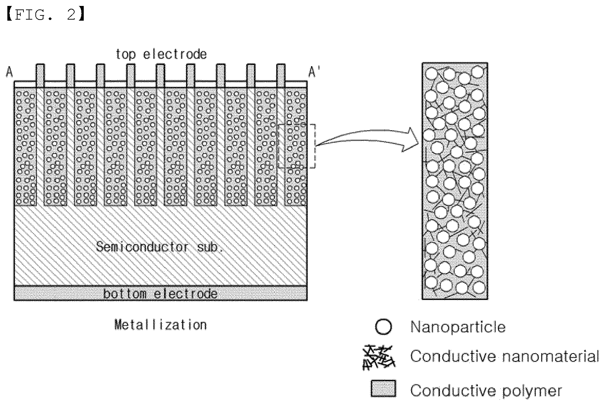

FIG. 2 is a schematic diagram of the radiation detection device according to the embodiment of the present invention.

Referring to FIG. 2, when radiation is incident into a detector device, the radiation is absorbed in the active layer area filled with a nanocomposite including a zero-dimensional nanoparticle, a conductive polymer, and a one-dimensional or two-dimensional conductive nanomaterial, thereby generating a plurality of electron-hole pairs through reaction with the zero-dimensional nanoparticle. The radiation detection device may be operated based on the principle that the generated electron-hole pairs move to an interface of an semiconductor-active layer area through a one-dimensional or two-dimensional nanomaterial with high carrier mobility and a conductive polymer, and electrons and holes are separated by an electric field formed by a voltage applied to an external top and bottom electrodes, respectively, and collected to provide signals to the outside, but the mechanism of the present invention is not limited thereto.

In an embodiment of the present invention, the at least one active layer area may be formed so that an aspect ratio (length/width) is 1 or more when a distance between the bottom electrode and the top electrode is taken as a length direction, and a direction orthogonal to the length direction is taken as a width direction. The aspect ratio may be preferably 1 or more, for example, 1 to 200, in terms of detection efficiency of the radiation detection device.

In another embodiment of the present invention, the at least one active layer area may have a width of 50 nm to 500 nm and a length of 1000 nm to 10 µm.

In an embodiment of the present invention, an upper end portion of a semiconductor substrate including the at least one active layer area may be preferably within 60% of an outermost portion of the semiconductor substrate in terms of the detection efficiency of the radiation detection device.

In an embodiment of the present invention, the active layer area may include at least two areas having the same shape.

In another embodiment of the present invention, the active layer area may include at least two areas having different shapes.

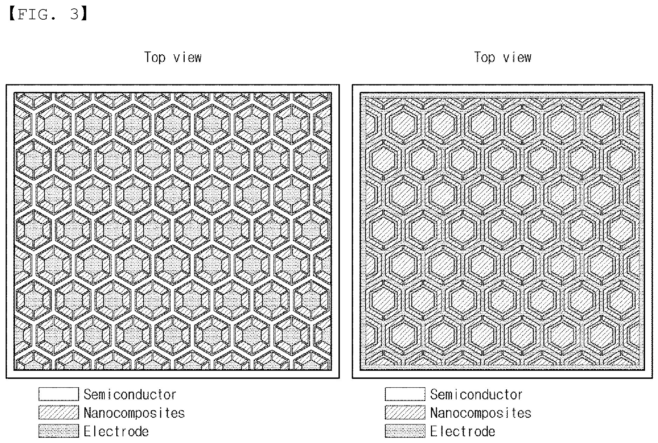

FIG. 3 illustrates a top view of a radiation detection device having different shapes according to an embodiment of the present invention.

Referring to FIG. 3, the radiation detection device according to the embodiment of the present invention may have a structure patterned by the at least one active layer area.

In the present invention, the patterned structure may be formed in various forms such as a circle and polygons such as a square, a hexagon, and an octagon, and may be designed in a way to maximize carrier collection efficiency, and is not limited to a special form. That is, the size, structure, shape, and position of the active layer area, the semiconductor substrate, and the electrode may be freely adjusted in a direction that radiation response may be maximized and the mobility and efficiency of carriers may be maximized.

In the present invention, the active layer area is filled with the nanocomposite.

The nanocomposite includes the zero-dimensional nanoparticle, the conductive polymer, and the one-dimensional or two-dimensional conductive nanomaterial. In this case, the nanocomposite may be prepared from a mixed solution of the zero-dimensional nanoparticle, the one-dimensional or two-dimensional conductive nanomaterial, and the conductive polymer, but the method of preparing a nanocomposite is not limited thereto. The method of preparing a nanocomposite will be described later.

In an embodiment of the present invention, the nanocomposite may include the zero-dimensional nanoparticle, the one-dimensional or two-dimensional conductive nanomaterial, and the conductive polymer in a weight ratio of, for example, 2-6:1:1. Specifically, the weight ratio of the zero-dimensional nanoparticle, the one-dimensional or two-dimensional conductive nanomaterial, and the conductive polymer is 2:1:1, 3:1:1, 4:1:1, 5:1:1, or 6:1:1, but is not limited thereto.

In the present invention, the zero-dimensional nanoparticle is a material that has a large surface area to volume ratio and thus provides a large area necessary for the movement of carriers generated through the radiation reaction. The zero-dimensional nanoparticle has at least one shape selected from the group consisting of quantum dot, nanocrystal, nanoparticle, and nanosphere, but is not limited thereto.

In an embodiment of the present invention, the zero-dimensional nanoparticle may include elements of groups 2 to 5 with an effective atomic number (Z) of 29 or more, but are not limited thereto.

In another embodiment of the present invention, the zero-dimensional nanoparticle may be a binary compound or a ternary compound, but is not limited thereto.

The ternary compound may include a perovskite-based (ABX₃) material, but is not limited thereto.

In another embodiment of the present invention, the zero-dimensional nanoparticle may include at least one selected from the group consisting of PbS, PbSe, PbTe, CdS, CdSe, CdTe, Cu₂S, and MAPbI₃, but is limited thereto.

In the present invention, the conductive polymer is not particularly limited as long as it allows electrons and holes formed by the zero-dimensional nanoparticle to move to the semiconductor interface when radiation is incident on the radiation detection device and absorbed in the active layer area. The conductive polymer includes at least one selected from the group consisting of polypyrrole, polythiophene, PEDOT:PSS (poly3,4-rthylene dioxythiophene-polystyrene sulfonate), polyaniline, pentacene, polymethyl methacrylate (PMMA), polyethyleneimine, poly 3-hexylthiophene, and phenyl-C61-butyric acid methyl ester, but is not limited thereto.

In the present invention, the one-dimensional or two-dimensional conductive nanomaterial may serve to form an additional conduction path that may increase the movement of carriers to the interface of the semiconductor-active layer area together with the conductive polymer, and increase the carrier diffusion length so that the generated carriers may move to the interface without being lost as much as possible. The one-dimensional or two-dimensional conductive nanomaterial has at least one shape selected from the group consisting of, for example, nanorod, nanowire, nanotube, nanobelts, nanoribbon, and nanosheet, but is not limited thereto.

In an embodiment of the present invention, the one-dimensional or two-dimensional conductive nanomaterial may include at least one selected from the group consisting of carbon nanotube (CNT), graphene, transition metal dichalcogenide (TMD), silicene, black phosphorus, and mxene, but is not limited thereto.

The transition metal dichalcogenide may include at least one selected from the group consisting of TiS₂, NiSe₂, PdS₂, PtS₂, PtSe₂, MoS₂, MoSe₂, WS₂, and WSe₂, but is not limited thereto.

The mxene may include at least one selected from the group consisting of Ti₂C, (Ti_{0.5},Nb_{0.5})₂C, V₂C, Nb₂C, Mo₂C Mo₂N, (Ti_{0.5},Nb_{0.5})₂C, Ti₂N, W_{2.33}C, Nb_{1.33}C, Mo_{1.33}C, Mo_{1.33}Y_{0.67}C, Ti₃C₂, Ti₃CN, Zr₃C₂, Hf₃C₂, Ti₄N₃, Nb₄C₃, Ta₄C₃, V₄C₃, (Mo,V)₄C₃, Mo₄VC₄, Mo₂TiC₂, Cr₂TiC₂, Mo₂ScC₂, and Mo₂Ti₂C₃, but is not limited thereto.

In an embodiment of the present invention, the at least one active layer area may be formed by one or more of photolithography, nanoimprinting lithography, nanosphere lithography, multi-beam lithography, anodic aluminum oxide (AAO), template, dry etching, wet etching, and metal-assisted chemical etching, but is not limited thereto.

In the present invention, the semiconductor substrate is not particularly limited as long as it is a material that may move so that electrons and holes formed in the active layer area may be collected in the electrode by the voltage applied to the electrode.

In an embodiment of the present invention, the semiconductor substrate is a material that supports the nanocomposite filled in the active layer area and allows carriers to smoothly move without trapping and recombination of the carriers, and for example, may include an inorganic semiconductor or an organic semiconductor. Examples of the materials of the semiconductor substrate may include one or more selected from the group consisting of silicon series such as c-Si, poly-Si, and a-Si, compound series such as SiC, GaAs, CdTe, and CdZnTe, and organic and polymer series with flexibility such as quartz, polyimide (PI), polycarbonate (PC), polystyrene (PS), polypropylene (PP), polyethylene naphthalate (PEN), polyoxymethylene (POM), polymethyl methacrylate (PMMA), polydimethyl siloxane (PDMS), polyetheretherketone (PEEK), polyethersulfone (PES), polyetherimide (PEI), and polyethylene terephthalate (PET), but is not limited thereto.

Another aspect of the present invention provides a method for manufacturing a radiation detection device.

The method for manufacturing a radiation detection device includes: forming at least one active layer area on a semiconductor substrate; filling the active layer area with a nanocomposite including a zero-dimensional nanoparticle, a conductive polymer, and a one-dimensional or two-dimensional conductive nanomaterial; and forming at least one bottom electrode and at least one top electrode on each of the lower and upper portions of the semiconductor substrate in which the active layer area is filled with the nanocomposite.

The components of the radiation detection device, for example, the semiconductor substrate, the active layer area, the nanocomposite, the bottom electrode, and the top electrode, are the same as described above.

In an embodiment of the present invention, the at least one active layer area may be formed by one or more of photolithography, nanoimprinting lithography, nanosphere lithography, multi-beam lithography, anodic aluminum oxide (AAO), template, dry etching, wet etching, and metal-assisted chemical etching, but the method of forming an active layer area is not limited thereto.

In an embodiment of the present invention, the nanocomposite may include the steps of forming a zero-dimensional nanoparticles-containing solution, forming a one-dimensional or two-dimensional nanomaterial-containing solution, and mixing the zero-dimensional nanoparticle-containing solution prepared above and the one-dimensional or two-dimensional conductive nanomaterial-containing solution. Next, the conductive polymer may be added to the mixed solution to obtain the nanocomposite through the polymer polymerization or sol-gel reaction.

In another embodiment of the present invention, before or after mixing the zero-dimensional nanoparticle-containing solution and the one-dimensional or two-dimensional conductive nanomaterial-containing solution, the method may further include purifying the zero-dimensional nanoparticle-containing solution and the one-dimensional or two-dimensional conductive nanomaterial-containing solution, and the purification may be performed according to the known methods such as removing suspended matter after centrifugation, and the method is not particularly limited.

In another embodiment of the present invention, the mixing of the zero-dimensional nanoparticle-containing solution and the one-dimensional or two-dimensional conductive nanomaterial-containing solution may include those dispersed through ultrasonic treatment, electromagnetic wave treatment, etc.

In an embodiment of the present invention, in the forming of the nanocomposite, the conductive polymer may be added to a mixed solution of the zero-dimensional nanoparticle and the 1-dimensional or 2-dimensional conductive nanomaterial and subjected to a polymer polymerization or sol-gel reaction at a temperature of 50 to 80°C for about 2 to 5 hours to form the nanocomposite solution.

In an embodiment of the present invention, a non-polar solvent may be used as a solvent for preparing the nanocomposite. The non-polar solvent is not limited thereto, and for example, hexane, toluene, chloroform, chlorobenzene, dichlorobenzene, or a mixed solvent thereof may be used.

The weight ratio of the zero-dimensional nanoparticle, the one-dimensional or two-dimensional nanomaterial, and the conductive polymer included in the mixed solution for preparing the nanocomposite may be, for example, 2-6:1:1. Specifically, the weight ratio is 2:1:1, 3:1:1, 4:1:1, 5:1:1, or 6:1:1, but is not limited thereto.

The present invention is not limited by the embodiments described above and the accompanying drawings, but is intended to be limited by the appended claims. Accordingly, various types of substitutions, modifications and changes will be possible by those skilled in the art without departing from technical spirit of the present invention described in the claims, and belong to the scope of the present invention.

## Claims

1. A radiation detection device, comprising:
at least one bottom electrode and at least one top electrode disposed at a spaced location; and a semiconductor substrate disposed between the bottom electrode and the top electrode,
wherein an upper end portion of the semiconductor substrate includes at least one active layer area, and
the active layer area is filled with a nanocomposite including a zero-dimensional nanoparticle, a conductive polymer, and a one-dimensional or two-dimensional conductive nanomaterial.

2. The radiation detection device of claim 1, wherein the at least one active layer area is formed so that an aspect ratio (length/width) is 1 or more when a distance between the bottom electrode and the top electrode is taken as a length direction, and a direction orthogonal to the length direction is taken as a width direction.

3. The radiation detection device of claim 2, wherein the width of the at least one active layer area is 50 nm to 500 nm, and the length of the at least one active layer area is 1000 nm to 10 um.

4. The radiation detection device of claim 1, wherein the radiation detection device comprises at least two active layer areas having the same shape.

5. The radiation detection device of claim 1, wherein the radiation detection device includes at least two active layer areas having different shapes.

6. The radiation detection device of claim 1, wherein the radiation detection device has a structure patterned by the at least one active layer area.

7. The radiation detection device of claim 1, wherein the zero-dimensional nanoparticle has at least one shape selected from the group consisting of quantum dot, nanocrystal, nanoparticle, and nanosphere.

8. The radiation detection device of claim 1, wherein the zero-dimensional nanoparticle comprises an element of groups 2 to 5 having an effective atomic number (Z) of 29 or more.

9. The radiation detection device of claim 8, wherein the zero-dimensional nanoparticle is a binary compound or a ternary compound.

10. The radiation detection device of claim 9, wherein the ternary compound comprises a perovskite-based (ABX₃) material.

11. The radiation detection device of claim 8, wherein the zero-dimensional nanoparticle comprises at least one selected from the group consisting of PbS, PbSe, PbTe, CdS, CdSe, CdTe, Cu₂S, and MAPbI₃.

12. The radiation detection device of claim 1, wherein the conductive polymer comprises at least one selected from the group consisting of polypyrrole, polythiophene, PEDOT:PSS (poly3,4-rthylene dioxythiophene-polystyrene sulfonate), polyaniline, pentacene, polymethyl methacrylate (PMMA), polyethyleneimine, poly 3-hexylthiophene, and phenyl-C61-butyric acid methyl ester.

13. The radiation detection device of claim 1, wherein the one-dimensional or two-dimensional conductive nanomaterial has at least one shape selected from the group consisting of nanorod, nanowire, nanotube, nanobelts, nanoribbon, and nanosheet.

14. The radiation detection device of claim 13, wherein the one-dimensional or two-dimensional conductive nanomaterial comprises at least one selected from the group consisting of carbon nanotube (CNT), graphene, transition metal dichalcogenide (TMD), silicene, black phosphorus, and mxene.

15. The radiation detection device of claim 14, wherein the transition metal dichalcogenide comprises at least one selected from the group consisting of TiS₂, NiSe₂, PdS₂, PtS₂, PtSe₂, MoS₂, MoSe₂, WS₂, and WSe₂.

16. The radiation detection device of claim 14, wherein the mxene includes at least one selected from the group consisting of Ti₂C, (Ti_{0.5},Nb_{0.5})₂C, V₂C, Nb₂C, Mo₂C Mo₂N, (Ti_{0.5},Nb_{0.5})₂C, Ti₂N, W_{1.33}C, Nb_{1.33}C, Mo_{1.33}C, M_{1.33}Y_{0.67}C, Ti₃C₂, Ti₃CN, Zr₃C₂, Hf₃C₂, Ti₄N₃, Nb₄C₃, Ta₄C₃, V₄C₃, (Mo,V)₄C₃, Mo₄VC₄, Mo₂TiC₂, Cr₂TiC₂, Mo₂ScC₂, and Mo₂Ti₂C₃.

17. The radiation detection device of claim 1, wherein the at least one active layer area is formed by one or more of photolithography, nanoimprinting lithography, nanosphere lithography, multi-beam lithography, anodic aluminum oxide (AAO), template, dry etching, wet etching, and metal-assisted chemical etching.

18. The radiation detection device of claim 1, wherein the semiconductor substrate comprises an inorganic semiconductor or organic semiconductor material.

19. A method for manufacturing a radiation detection device, comprising:
forming at least one active layer area on a semiconductor substrate;
filling the active layer area with a nanocomposite comprising a zero-dimensional nanoparticle, a conductive polymer, and a one-dimensional or two-dimensional conductive nanomaterial; and
forming at least one bottom electrode and at least one top electrode on each of lower and upper portions of the semiconductor substrate in which the active layer area is filled with the nanocomposite.

20. The method of claim 19, wherein the at least one active layer area is formed by one or more of photolithography, nanoimprinting lithography, nanosphere lithography, multi-beam lithography, anodic aluminum oxide (AAO), template, dry etching, wet etching, and metal-assisted chemical etching.

21. The method of claim 19, wherein the forming of the at least one active layer area comprises forming a pattern by the at least one active layer area.

22. The method of claim 19, wherein the nanocomposite is formed from a mixed solution of the zero-dimensional nanoparticle, the one-dimensional or two-dimensional conductive nanomaterial, and the conductive polymer at a weight ratio of 2-6:1:1.
